# EUROPEAN PATENT SPECIFICATION

(11) **EP 0 504 431 B1**
(45) Date of publication and mention of the grant of the patent: **20.03.1996**
(21) Application number: 91917693.3
(22) Date of filing: 09.10.1991
(51) Int. Cl.: G03F 7/42, H01L 21/311

(54) **METHOD OF REMOVING ORGANIC COATING**
VERFAHREN ZUM ENTFERNEN ORGANISCHER ÜBERZÜGE
PROCEDE D'ELIMINATION DE REVETEMENTS ORGANIQUES

(30) Priority: 09.10.1990 JP 270898/90
(43) Date of publication of application: 23.09.1992
(73) Proprietor: CHLORINE ENGINEERS CORP., Ltd., Tokyo 105 (JP)
(72) Inventor: KASHIWASE, Masaharu, Okayama-shi, Okayama 700 (JP); MATSUOKA, Terumi, Okayama-shi, Okayama 700 (JP)
(74) Representative: Diamond, Bryan Clive
(86) International application number: JP9101374
(87) International publication number: WO9206489

(56) References cited:
- EP-A- 0 259 985
- EP-A- 0 311 817
- EP-A- 0 344 764
- FR-A- 2 231 110
- JP-A-62 213 127
- JP-A-64 008 630
- JP-A-64 076 726
- PATENT ABSTRACTS OF JAPAN vol. 6, no. 136 (E-120)23 July 1982 & JP-A-57 062 530

## Description

### FIELD OF THE INVENTION

The present invention relates to a method for removing an organic film, and in particular to a method for removing a photo resist film, i.e. an organic macromolecular compound, used in manufacture of semiconductor device by photolithography without damaging the semiconductor device.

### BACKGROUND ART

In a process for manufacturing a semiconductor device such as IC, LSI, etc., an organic photosensitive macromolecular compound is coated on a semiconductor substrate such as silicon or a glass substrate in order to form a fine electric element or circuit, and it is exposed to ionizing radiation such ultraviolet ray through a photo mask where a pattern such as a predetermined circuit is formed. Then, the photo resist is developed, and a positive or negative circuit pattern is prepared on the photo resist on the substrate, and a film is formed on a substrate without the photo resist by CVD, sputtering, etc. Or, chemical etching, RIE (reactive ion etching), diffusion by heating impurity element, or ion implantation are performed. After a series of processings are completed, the film of photo resist on the substrate is removed by chemical processing. In a process for manufacturing IC and LSI, after various processings by coating such photo resist, the photo resist film is removed not only by a single procedure but by several procedures.

To remove the photo resist film, various methods are adopted, and it is necessary to completely remove the photo resist film because the subsequent processes may be affected adversely if the removal of the photo resist is incomplete. Particularly, in case line width of a circuit of semiconductor device to be formed is finer because of the introduction of higher integration of the semiconductor device in recent years, the influence of residue of the photo resist film becomes bigger than a case with lower integration, and it is necessary to remove it completely.

Various methods are employed for the removal of the photo resist film, including a wet method using a chemical solution and a dry method using oxygen plasma.

In a wet method for removing photo resist film, sulfuric acid is normally used, and it is generally practiced to mix it with hydrogen peroxide to increase oxidizing ability of the sulfuric acid.

In case the photo resist film is removed using a mixed solution of sulfuric acid and hydrogen peroxide, a chemical solution such as sulfuric acid attached on the film is removed after the removal of the photo resist film, and ultra pure water is used for removing and cleaning the residue.

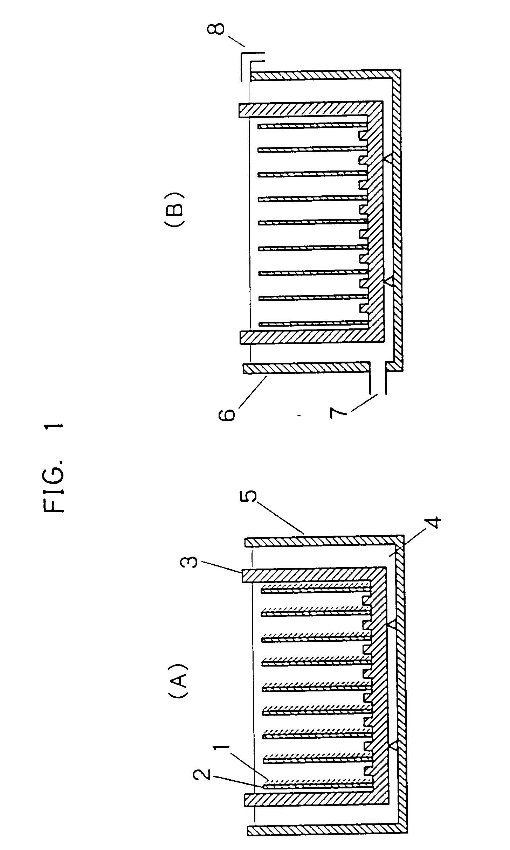

To remove an organic film by a normal wet method, a plurality of wafers 2 with organic films 1 formed on them are accommodated in a wafer cassette 3, and this is immersed for a certain period time in a processing tank 5 filled with a processing solution 4 such as a mixed solution of sulfuric acid and hydrogen peroxide as shown in Fig. 1 (A). Then, it is immersed in a rinse tank 6 with ultra pure water to remove chemical solution attached on the substtrate or residue of the photo resist film. There are many types of rinse tank, while an overflow type tank is widely used and the rinse tank is provided with an ultra pure water inlet 7 and an outlet 8 for the solution.

In the removal of the photo resist film by the mixed solution of sulfuric acid and hydrogen peroxide, oxidizing decomposition of the photo resist film by oxygen generated through decomposition of hydrogen peroxide plays an important role. To maintain oxidizing ability of this mixed solution, it is necessary to replenish a new solution by removing sulfuric acid and hydrogen peroxide, which have been consumed by oxidizing decomposition of the photo resist film and have decreased concentration.

A method has been proposed as the Japanese Patent Publication No. 52-12063, by which ozone is supplied to sulfuric acid to remove the photo resist film in order to obtain the same effect without processing of waste solution with its removing ability or without the procedure to replenish the solution.

In case of a normal photo resist film, it is possible to remove the photo resist film by the introduction of ozone into sulfuric acid as described above. In some cases, however, when reactive ion etching is performed or high concentration arsenic is used by ion implantation for doping of impurities to semiconductor, the photo resist film is not removed completely and residue remains. In case high energy ions are used in ion implantation method, arsenic and others used in the ion implantation may chemically react with the photo resist, and the photo resist film may be turned to a substance, which is not easily oxidized. As the result, oxidizing decomposition is prevented because of the processing solution.

The sulfuric acid used for the processing of the photo resist film has high concentration, and the ratio of water in the procesing solution of the photo resist film is low. When ozone with lower solubility in sulfuric acid is introduced into the sulfuric acid containing lower ratio of water, ozone is less dissolved into the processing solution. Thus, the introduction of ozone into the processing solution does not necessarily result in effective use of ozone. Accordingly, even when ozone is introduced into sulfuric acid, oxidizing ability of ozone is not effectively utilized.

On the other hand, in the processing by chemical solution containing sulfuric acid and hydrogen peroxide or chemical solution with dissolved ozone, various facilities for introducing the chemical solution are required, and also facilities for processing waste solution are needed. Further, it is necessary to provide a process to remove chemical solution by completely rinsing with ultra pure water after the processing of chemical solution.

Under such circumstances, the dry method for processing is now more frequently used instead of the wet processing method using chemical solution. A typical dry method for removing photo resist film is a method using oxygen plasma. According to this method, oxygen plasma is generated by high frequency energy to oxidize photo resist film and provides high oxidizing ability. However, during generation of plasma, high energy charged particles and ions are generated, and dielectric breakdown or property of the semiconductor device to be manufactured are impaired, and there is now strong demand on a dry method for removing photo resist without such problems.

To overcome these difficulties, a method is now adopted to separate the plasma generator from the processing unit to remove organic substance. There is another dry method is adopted to remove organic film using ozone, which has high oxidizing ability next to fluorine.

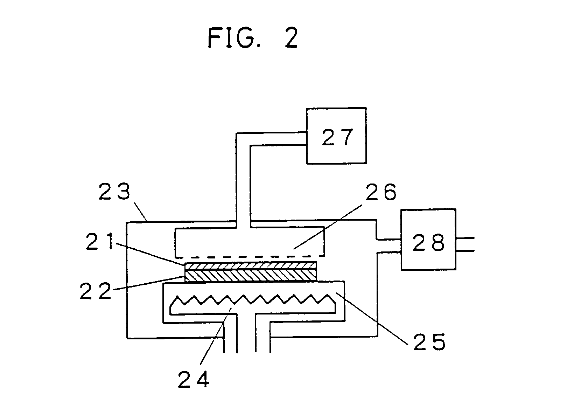

Fig. 2 shows the dry method for removing organic substance by ozone. A wafer 22 such as silicon, where an organic film 21 is formed, is placed on a substrate stage 25 kept at 200°C to 300°C by a heating device 24 in a processing unit 23, and a gas containing high concentration ozone generated by an ozone generator 27 is injected on the organic film through injection nozzles 26 mounted on upper portion of the processing unit, and the organic film is removed by ozone. To attain uniform processing of the organic film, the substrate stage 25 is rotated. To effectively utilize ozone, which is vulnerable to thermal decomposition, the portions for introducing and injecting ozone are cooled down so that high concentration ozone can be introduced into the processing unit. To decompose ozone remaining in the gas, which is discharged from the processing unit, an ozone decomposing unit 28 is provided.

The dry processing by ozone is a very effective method without damaging the semiconductor device, and it is possible to remove the photo resist film by the processing using ozone in case of a normal photo resist film. However, in case reactive ion etching is performed or in case doping of impurities such as arsenic is carried out at high concentration by ion implantation, photo resist film is not completely removed and the residue may remain.

Even in such case, it is possible to accomplish processing by increasing heating temperature of the substrate stage of the processing unit, while metal such aluminum used in the semiconductor device may undergo unnecessary diffusion by heat and the property of the semiconductor device may be deteriorated. Thus, there is also a problem in the processing at high temperature.

In removing the organic film by oxygen plasma, the processing by plasma for long time may adversely affect the semiconductor device, and there is a problem in processing by oxygen plasma for long period in case of an organic film with high ion implantation and with high tolerance to oxygen plasma.

It is an object of the present invention to provide a method, by which it is possible to remove a photo resist film, which is difficult to remove by a wet method using chemical solution, and also to remove photo resist film, which is deteriorated by ion implantation and is difficult to remove without processing at high temperature for long time by a dry method, by a processing at relatively low temperature within short time and without impairing semiconductor device.

### DISCLOSURE OF THE INVENTION

After a photo resist film is processed by immersing it in a mixed solution containing sulfuric acid and hydrogen peroxide according to a normal wet method for removing photo resist film, and/or a dry processing using ozone or oxygen plasma is then performed at relatively low temperature and in relatively short time without impairing semiconductor device. A substrate such as silicon, from which organic substance is not completely removed, is rinsed by ultra pure water containing ozone in dissolved and bubbling state (hereinafter referred as "solution containing ozone). Thus, photo resist film after ion implantation with residue attached on it, not removable by normal wet type processing or by processing using ozone, can be completely removed.

### BRIEF DESCRIPTION OF THE DRAWINGS

Fig. 1 shows a processing for removing an organic film by a wet method;
Fig. 2 shows a processing for removing an organic substance by a dry method using ozone;
Fig. 3 represents a processing for removal by ultra pure water containing ozone after a wet processing using an oxidizing agent of the present invention; and
Fig. 4 shows a processing for removal by ultra pure water containing ozone after a dry processing of an organic substance using ozone according to the present invention.

### BEST MODE FOR CARRYING OUT THE INVENTION

According to the present invention, a photo resist film is processed by immersing it in a mixed solution of sulfuric acid and hydrogen peroxide by a normal wet method for removing photo resist film, and a dry processing using oxygen plasma is performed at relatively low temperature and in relatively short time without impairing semiconductor device. Thus, a substrate such as silicon, from which organic substance is not completely removed, is rinsed by a solution containing ozone in dissolved and bubbling state (a solution containing ozone), prepared by introducing ozone into ultra pure water. As the result, a photo resist film after ion implantation with residue attached on it, not removable by normal wet type processing or by processing using ozone, can be completely removed.

The processing by ozone is performed by processed water, which is prepared by supplying a gas containing ozone into ultra pure water. In supplying ozone into ultra pure water, not only gaseous ozone obtained from a silent discharge type generator, but also high concentration ozone water, obtained by an electrolysis unit for water are used, in which high concentration ozone water prepared by dissolving gaseous ozone in ultra pure water in advance or a lead dioxide electrode as anode and a cation exchange membrane of fluororesin type is used as solid macromolecular electrolyte.

To obtain high concentration ozone in a silent discharge type ozone generator, it is desirable to supply a gas with high oxygen concentration such as pure oxygen to the ozone generator.

Because the photo resist film is oxidized and decomposed in the processing using ozone by strong oxidizing action of oxygen generated when ozone is decomposed, it is possible to promote the processing by injecting ozone by increasing temperature of ultra pure water in a processing tank by ozone. In this case, it is preferable to maintain the temperature in the ozone processing tank at 40°C to 100°C.

If the concentration of the gas containing ozone to be supplied into the ozone processing tank is higher, higher rinsing effect can be obtained. Porous plate made of glass, ceramics, etc. with many fine pores may be provided on a portion to introduce ozone into ultra pure water. Thus, it is possible to promote the processing by ozone through promotion of dissolving of the gas containing ozone into ultra pure water by increasing contact with ultra pure water through formation of fine bubble by the porous plate.

Because ozone has very high oxidizing effect and adversely affects human body, it is necessary to decompose ozone to oxygen by furnishing an ozone decomposing unit to decompose the discharged ozone in the ozone processing tank.

By the method of the present invention, it is possible to remove the photo resist film of both positive and negative types.

In the following, description will be given on the present invention, referring to the drawings.

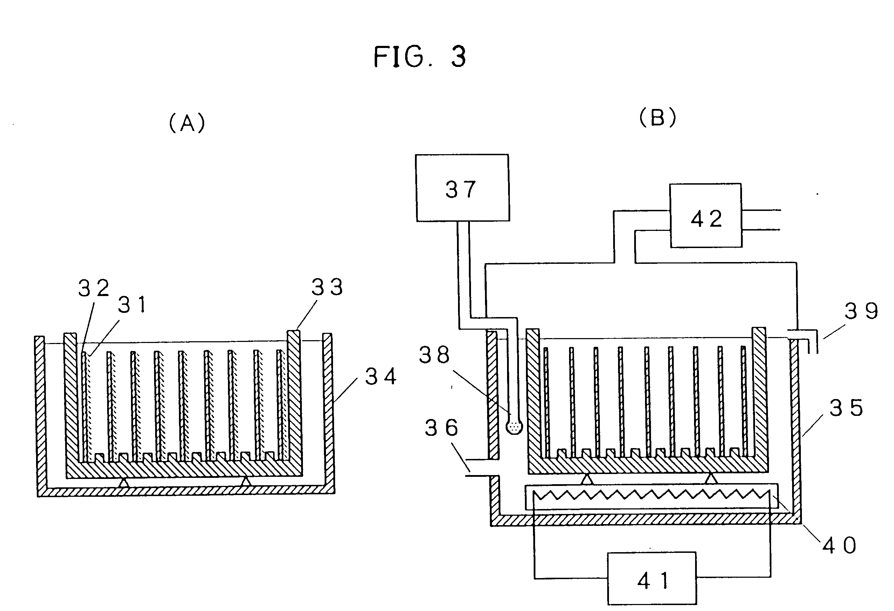

Fig. 3 shows an apparatus to be used for a method for removing a photo resist film in ultra pure water containing ozone after the photo resist film has been processed by a chemical solution. As shown in Fig. 3 (A), a plurality of substrates 32, on which photo resist films 31 are formed, are accommodated in a cassette 33, and this is immersed for a certain period of time in a wet processing tank 34, which is filled with a processing solution such as a mixed solution of sulfuric acid and hydrogen peroxide, and the photo resist films are removed by a wet method. Then, the cassette is immersed in an ozone processing tank 35 shown in Fig. 3 (B) and is processed. The ozone processing tank comprises a supply pipe 36 for ultra pure water, an ozone supply pipe 38 for supplying ozone generated in an ozone generator 37, and a solution discharge pipe 39. The temperature of the solution in the ozone processing tank is adjusted to a desired value by a heater 40 and a temperature regulator 41.

To prevent the contamination of working environment by ozone discharged from the ozone processing tank, an ozone decomposing unit 42 is provided, and the discharge of ozone to the working environment is prevented.

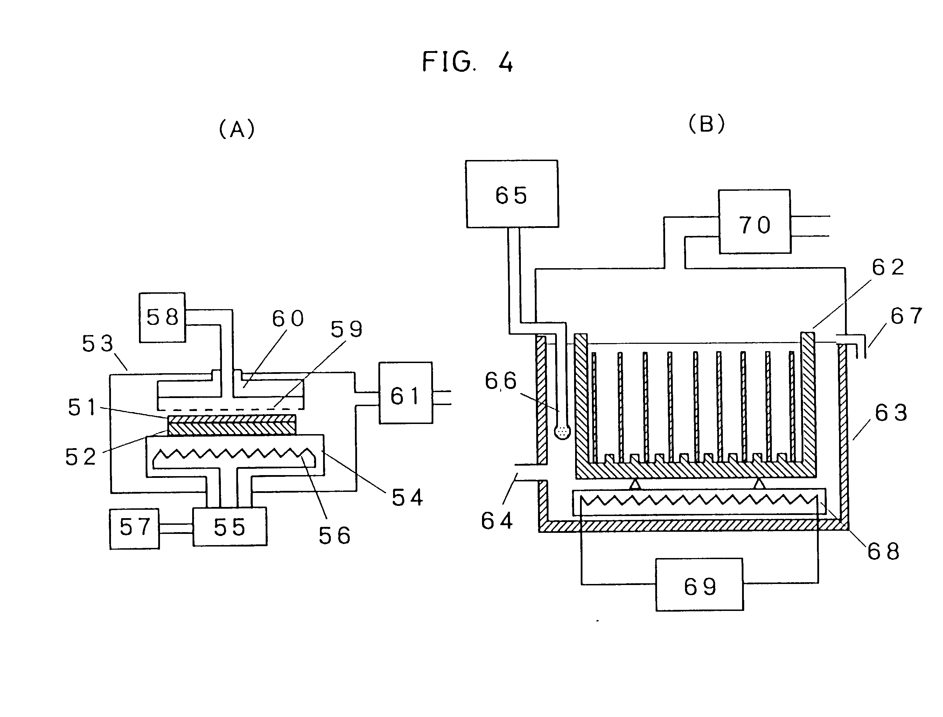

Fig. 4 shows a method for processing photo resist films in ultra pure water containing ozone by injecting ozone after the films have been processed by a dry processing using ozone.

As shown in Fig. 4 (A), a substrate 52 with photo resist film 51 formed on it is placed on a substrate stage 54 in a processing chamber 53. The substrate stage 54 is rotatable by a rotating mechanism 55, and a heating element 56 is furnished in the substrate stage, and temperature is maintained at a predetermined value by a temperature controller 57.

A gas containing ozone is generated in an ozone generator 58 and is injected through a plurality of injection nozzles 59, placed face-to-face to the substrate, toward the surface of the substrate. To prevent decomposition of the gas containing ozone by heat, a channel toward the processing chamber and the injection nozzles are cooled by a cooling medium 60 so that the gas containing high concentration ozone can reach the substrate surface uniformly.

In the gas discharged from the ozone processing chamber, unreacted ozone remains together with carbon dioxide generated by decomposed organic substances and water, and this cannot be discharged. Thus, it is necessary to discharge the gas after ozone has been completely decomposed by the ozone decomposing unit 61, which comprises an ozone decomposing heater or an ozone decomposing catalyst.

In case the dry processing using ozone is performed by leaf type processing as in the present embodiment, the processing speed can be substantially increased by furnishing a plurality of processing chambers in a dry processing unit using ozone.

After the processing by ozone has been completed, the substrate 52 is housed in a cassette 62 as shown in Fig. 4 (B) just as in the case of the substrate after the completion of processing by chemical solution. It is then immersed in an ozone processing tank 63, and the residue is removed by water containing ozone.

The ozone processing tank comprises an ultra pure water supply pipe 64, an ozone supply pipe 66 for supplying ozone generated in an ozone generator 65, and a solution discharge pipe 67. The temperature of the solution in the ozone processing tank is regulated to a predetermined value by a heater 68 and a temperature regulator 69.

It is preferable to furnish an inlet for the supply pipe 64 of ultra pure water on lower portion of the ozone processing tank and to provide the solution discharge pipe on upper portion of the ozone processing tank so that the solution is discharged by overflow.

An ozone decomposing unit 70 is furnished to prevent the contamination of the working environment by ozone discharged from the ozone processing tank.

In the following, the features of the invention will be described referring to several examples.

### (Example 1)

On a silicon wafer of 150 mm in diameter, positive type photo resist (OFPR-800; Tokyo Ohka Kogyo Co., Ltd.) is coated in thickness of 1.5 µm, and exposure and development were performed. Then, ion implantation was carried out with arsenic at concentration of 1 x 10¹⁵/cm to 3 x 10¹⁵/cm. This was immersed for 5 minutes in a processing solution, which contained sulfuric acid of 90% concentration and hydrogen peroxide of 35% concentration mixed at a ratio of 4:1. Further, this was immersed for 5 minutes at room temperature in ultra pure water with gas containing varying concentration of ozone and is then rinsed in running ultra pure water.

The removal of photo resist film is not performed uniformly from wafer surface but it is influenced by a pattern formed on the photo resist surface. The present inventors studied a method to evaluate the removal of photo resist film and evaluated it by the following method.

The mode of detachment differs according to form, line width, area, etc., and the larger the line width or the area is, the more rarely the detachment occurs. Thus, the pattern was divided into four parts for observation: portion with identification symbol, pad portion, lead portion and wiring portion, with difficulty of detachment in this order. Then, the wiring portion was divided into wiring top and a portion around wiring for observation.

The results are summarized in Table 1. A photo resist film completely detached is represented by o, a photo resist film partially remaining is shown by Δ, and a photo resist film not removed is shown by x. Comparison was also made by numerical values with complete removal as 100.

**Table 1**

| Arsenic infusion conc. (cm⁻) | Ozone conc. (ppm) | Identification symbol | Pad | Lead | Wiring | Overall evaluation of detachment |
|---|---|---|---|---|---|---|
| 1 x 10¹⁵ | 95000 | o | o | o | o | 100 |
| 1 x 10¹⁵ | 57000 | o | o | o | o | 100 |
| 1 x 10¹⁵ | 41700 | o | o | o | o | 100 |
| 2 x 10¹⁵ | 95000 | o | o | o | o | 100 |
| 2 x 10¹⁵ | 57000 | o | o | o | o | 100 |
| 2 x 10¹⁵ | 41700 | Δ | Δ | Δ | o | 65 |
| 3 x 10¹⁵ | 95000 | o | o | o | o | 100 |
| 3 x 10¹⁵ | 57000 | Δ | Δ | Δ | o | 65 |
| 3 x 10¹⁵ | 41700 | Δ | Δ | Δ | o | 65 |

### (Example 2)

Instead of the gas containing ozone supplied to the ozone processing tank, ultra pure water with dissolved ozone was used, and the same processing as in the Example 1 was performed This was evaluated by the same method as in the Example 1 and the results are shown in Table 2. The ozone concentration in ultra pure water was expressed as ozone water concentration in Table 2.

**Table 2**

| Arsenic infusion conc. (cm⁻) | Ozone water conc. (ppm) | Identification symbol | Pad | Lead | Wiring | Overall evaluation of detachment |
|---|---|---|---|---|---|---|
| 1 x 10¹⁵ | 21.8 | o | o | o | o | 100 |
| 2 x 10¹⁵ | 23.9 | o | o | o | o | 100 |
| 3 x 10¹⁵ | 23.3 | Δ | o | o | o | 95 |

### (Example 3)

By varying the temperature of ultra pure water in the ozone processing tank, processing was performed by the same procedure as in the Example 1 except that the gas containing ozone was injected. The results are summarized in Table 3.

**Table 3**

| Arsenic infusion conc. (cm⁻) | Liquid temperature (°C) | Ozone conc. (ppm) | Identification symbol | Pad | Lead | Wiring | Overall evaluation of detachment |
|---|---|---|---|---|---|---|---|
| 3 x 10¹⁵ | 25 | 57000 | Δ | Δ | Δ | o | 65 |
| 3 x 10¹⁵ | 35 | 57000 | Δ | Δ | Δ | o | 65 |
| 3 x 10¹⁵ | 50 | 57000 | Δ | o | o | o | 95 |
| 3 x 10¹⁵ | 100 | 57000 | o | o | o | o | 100 |

### (Example 4)

The processing was performed only by the mixed solution of sulfuric acid and hydrogen peroxide and not by ozone, and the removal of photo resist was evaluated by the same method as in the Example 1. The results are shown in Table 4.

**Table 4**

| Arsenic infusion conc. (cm⁻) | Identification symbol | Pad | Lead | Wiring | Overall evaluation of detachment |
|---|---|---|---|---|---|
| 1 x 10¹⁵ | o | o | o | o | 100 |
| 1 x 10¹⁵ | o | o | o | o | 100 |
| 2 x 10¹⁵ | Δ | Δ | Δ | Δ | 100 |
| 2 x 10¹⁵ | Δ | Δ | Δ | o | 100 |
| 3 x 10¹⁵ | Δ | Δ | Δ | o | 100 |
| 3 x 10¹⁵ | Δ | Δ | Δ | o | 65 |
| 3 x 10¹⁵ | Δ | Δ | Δ | o | 65 |

### (Example 5)

On a silicon wafer of 150 mm in diameter, positive type photo resist (OFPR-800; Tokyo Ohka Kogyo Co., Ltd.) was coated in thickness of 1.5 µm, and exposure and development were performed. Then, ion implantation was performed with arsenic at concentration of 1 x 10¹⁵/cm to 4 x 10¹⁵/cm. This was placed on a substrate stage in a dry ozone processing unit. With the substrate stage maintained at 300°C, oxygen containing ozone at concentration of 60,000 ppm was supplied from injection nozzles at a flow rate of 10 liters/min. for 2 minutes.

In the ozone processing tank with the gas containing ozone at concentration of 95,000 ppm in ultra pure water, rinsing was performed for 5 minutes when arsenic concentration was 3 x 10 ¹⁵/cm, and for 6 minutes when it was 4 x 10¹⁵/cm. This was evaluated by the same procedure as in the Example 1, and the results are shown in Table 5.

**Table 5**

| Arsenic infusion conc. (cm⁻) | Liquid temperature (°C) | Ozone conc. (ppm) | Identification symbol | Pad | Lead | Wiring | Overall evaluation of detachment |
|---|---|---|---|---|---|---|---|
| 1 x 10¹⁵ | 25 | 95000 | o | o | o | o | 100 |
| 2 x 10¹⁵ | 25 | 95000 | o | o | o | o | 100 |
| 3 x 10¹⁵ | 25 | 95000 | o | o | o | o | 100 |
| 4 x 10¹⁵ | 25 | 95000 | o | o | o | o | 100 |

### (Example 6)

Ion implantation was performed by the same procedure as in the Example 5 on a silicon wafer with arsenic at concentration of 3 x 10¹⁵/cm and 4 x 10 ¹⁵/cm, and this was immersed for 5 minutes in a processing solution containing sulfuric acid of 90% concentration and hydrogen peroxide of 35% concentration mixed at a ratio of 4:1. Then, this was immersed in an ozone processing solution of ultra pure water containing ozone for 5 minutes when the arsenic concentration was 3 x 10¹⁵/cm, and for 6 minutes when the arsenic concentration was 4 x 10¹⁵/cm, and this was rinsed for 5 minutes under running ultra pure water.

The removal of the photo resist was evaluated by the same procedure as in the Example 5, and the results are given in Table 6.

**Table 6**

| Arsenic infusion conc. (cm⁻) | Liquid temperature (°C) | Ozone conc. (ppm) | Identification symbol | Pad | Lead | Wiring | Overall evaluation of detachment |
|---|---|---|---|---|---|---|---|
| 3 x 10¹⁵ | 25 | 95000 | o | o | o | o | 100 |
| 4 x 10¹⁵ | 25 | 95000 | Δ | Δ | Δ | o | 60 |

### INDUSTRIAL APPLICABILITY

By the method for processing organic film according to the present invention, it is possible to completely remove a photo resist film, which has been deteriorated by high concentration ion implantation or by reactive ion etching and which has been difficult in the past to remove by a dry type processing to remove organic film or by a wet type processing using solution containing sulfuric acid and hydrogen peroxide. This makes it possible to shorten the manufacturing process and to reduce percent defective in the manufacture of semiconductor device.

## Claims

1. A method for removing an organic film from a substrate, the method comprising removing the organic film by subjecting the film to a gas containing oxygen plasma or ozone in a dry method or a solution containing an oxidizing agent in a wet method, characterised in that said method further comprises immersing said substrate in an ozone processing tank containing a solution of ozone in ultra pure water, ozone being injected into said ultra pure water and said ozone contacting the organic film on the substrate in the form of gas bubbles.

2. A method for removing an organic film according to Claim 1, wherein said oxidizing agent is a mixed solution of sulfuric acid and hydrogen peroxide.

3. A method for removing an organic film according to Claim 1, wherein the organic film has been processed by reactive ion etching or ion implantation.

4. A method for removing an organic film according to Claim 1, wherein the solution in the ozone processing tank is heated.

## Patentansprüche

1. Verfahren zum Entfernen eines organischen Überzugs von einem Substrat, bei dem der organische Film in einem Trockenverfahren mittels eines Gases, das ein Sauerstoffplasma oder Ozon enthält, oder in einem Naßverfahren mittels einer Lösung, die ein Oxidationsmittel enthält, entfernt wird, dadurch gekennzeichnet, daß das Verfahren ferner das Eintauchen des Substrats in einen Ozonbearbeitungstank, der eine Lösung von Ozon in ultrareinem Wasser enthält, umfaßt, wobei Ozon in das ultrareine Wasser injiziert wird und den organischen Überzug auf dem Substrat in Form von Gasblasen kontaktiert.

2. Verfahren zum Entfernen eines organischen Überzugs nach Anspruch 1, wobei das Oxidationsmittel eine gemischte Lösung aus Schwefelsäure und Wasserstoffperoxid ist.

3. Verfahren zum Entfernen eines organischen Überzugs nach Anspruch 1, wobei der organische Überzug durch reaktives Ionenätzen oder Ionenimplantation hergestellt worden ist.

4. Verfahren zum Entfernen eines organischen Überzugs nach Anspruch 1, wobei die Lösung in dem Ozonbearbeitungstank erwärmt wird.

## Revendications

1. procédé pour éliminer un film organique d'un substrat, le procédé consistant à éliminer le film organique en soumettant le film à un gaz contenant un plasma d'oxygène ou de l'ozone dans un procédé à sec ou à une solution contenant un agent oxydant dans un procédé en milieu humide, caractérisé en ce que ledit procédé consiste en outre à immerger le substrat dans une cuve de traitement à l'ozone contenant une solution d'ozone dans de l'eau ultra-pure, l'ozone étant injecté dans l'eau ultra-pure et l'ozone étant en contact avec le film organique sur le substrat sous la forme de bulles de gaz.

2. Procédé d'élimination d'un film organique selon la Revendication 1, dans lequel ledit oxydant est une solution mixte d'acide sulfurique et d'eau oxygénée.

3. Procédé d'élimination d'un film organique selon la Revendication 1, dans lequel le film organique a été traité par attaque par ions réactifs ou implantation ionique.

4. Procédé d'élimination d'un film organique selon la Revendication 1, dans lequel la solution contenue dans la cuve de traitement à l'ozone est chauffée.
